(19) Europäisches Patentamt
European Patent Office
Office européen des brevets

(11) Publication number: **0 133 339**
**A2**

# (12) EUROPEAN PATENT APPLICATION

(21) Application number: **84304017.1**

(22) Date of filing: **14.06.84**

(51) Int. Cl.[4]: **H 01 L 29/62**, H 01 L 29/10, H 01 L 21/00

(30) Priority: **29.07.83 US 518643**

(43) Date of publication of application: **20.02.85**
**Bulletin 85/8**

(84) Designated Contracting States: **DE FR GB NL**

(71) Applicant: **TRW INC., 23555 Euclid Avenue, Cleveland Ohio 44117 (US)**

(72) Inventor: **Harrington, Alan Lloyd, 14502 Yukon Avenue, Hawthorne California 90250 (US)**
Inventor: **Rodov, Vladimir, 818 So. Juanita Avenue, Redondo Beach California 90277 (US)**

(74) Representative: **Allden, Thomas Stanley et al, A.A. THORNTON & CO. Northumberland House 303-306 High Holborn, London WC1V 7LE (GB)**

## (54) Silicide bipolar transistor and process for making the transistor.

(57) A bipolar transistor having a base contact partially made of silicide and a sub-micron geometry is disclosed. This transistor has a low parasitic base resistance. A lift-off method and an etch-back method for forming this transistor are also disclosed.

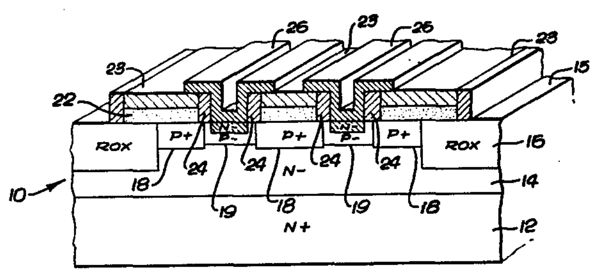


EP 0 133 339 A2

# SILICIDE BIPOLAR TRANSISTOR AND PROCESS FOR MAKING THE TRANSISTOR

## BACKGROUND OF THE INVENTION

### 1. Field of the Invention

This invention relates to bipolar transistors and more particularly to interdigitated bipolar transistors with a very low parasitic base resistance ($r_b'$).

In bipolar transistors, the ratio of the emitter perimeter to base area significantly affects the magnitude of $r_b'$. A comparatively high emitter perimeter to base area ratio means $r_b'$ will be low. Because a relatively high value for $r_b'$ limits the current gain of the transistor, it is desirable to reduce $r_b'$ as much as possible.

### 2. Description of the Prior Art

One method for reducing $r_b'$ is to make a transistor with an interdigitated geometry. An interdigitated transistor has a plurality of elongated, spaced apart base regions formed on the surface of the substrate, which is the collector. The emitter regions are also usually elongated spaced apart regions formed on top of the base regions. Frequently, the base regions have an ohmic base contact region that separates base regions from each other. The base regions or the base contact regions are connected together, forming a comb-like structure and the emitter regions are joined together, forming a second comb-like structure. The backs of each comb-like structure are parallel to each other and the teeth of each structure project toward the back of the other structure. In interdigitated transistors, the magnitude of $r_b'$ still is affected by the resistivity of the material used for these base contact regions and the limited number of base and emitter regions that can be placed on the device due to the limitations of microlithography.

To minimize $r_b'$, the emitter and base regions may be made quite small, thereby maximizing the number of emitter and base regions on the device. Using present microlithography technology for forming semiconductor masks, it is possible to develop extremely small (i.e., having dimensions less of less than a micron) emitter and base regions to reduce the parasitic base resistance. Several techniques are available for reducing the geometry to less than one micron. In an interdigitated transistor, a sub-micron geometry has features that are less than one micron. Some examples are an emitter to base junction that is less than one micron wide or a separation between the edge of the base and the edge of the emitter that is less than one micron wide. However, technologies that can produce submicron geometries are significantly more expensive than technologies which provide a geometry greater than one micron.

Some relatively inexpensive techniques for formation of submicron geometries are disclosed in U.S. Patent No. 4,157,269 to Ning et al. and U.S. Patent No. 4,319,932 to Jambotkar. In Ning and Jambotkar, the transistor uses a polysilicon ohmic base contact. A problem with a polysilicon base contact is that polysilicon has a relatively high linear resistance, thereby raising $r_b'$. In addition, Ning and Jambotkar use reach through regions for forming the contact for the collector. These reach throughs, which provide access to the collector region remote from the collector to base junctions, limit the number of emitter and base regions that can be placed on the device. Furthermore, a transistor that has reach through is not readily adaptable to an interdigited geometry.

The present invention uses silicides as part of the ohmic base contact to decrease $r_b'$. A silicide is a mixture of silicon with a metal such as hafnium, platinum, tungsten, molybdenum, tantalum, titanium or rhodium. Generally, the linear resistance of polysilicon is approximately one order of magnitude greater than the linear resistance of most silicides. Silicides have been used for device interconnections on integrated circuits as shown by U.S. Patent No. 4,329,706 to Crowder et al. and as fusable links for integrated circuit devices as shown by U.S. Patent No. 4,235,295 to Price. The prior art does not disclose the use of silicides in bipolar transistors to decrease $r_b'$.

Thus, it is an object of the present invention to form a bipolar transistor that has a small parasitic base resistance.

SUMMARY OF THE INVENTION

In accordance with the principles of the present invention, improved bipolar devices and methods for fabricating the same are disclosed. Silicide is used as part of the ohmic base contacts to decrease $r_b'$. The part of the base contacts that are made of silicide are also used as masks for formation of the base regions. The silicide is also an impurity source used to form the remainder of the base contact regions.

The invention involves the use of silicide regions to form the masks for implanting the dopants to form the base and emitter regions. A plurality of silicide/dielectric plateaus are formed with a window for the base region separating the plateaus. Each plateau acts as a mask for diffusion or ion implantation of the base regions. An inner side wall for the window is formed by conformal coating a dielectric to act as an additional mask for the implantation of an emitter region in each base region. The thickness of this wall controls the size of the emitter region and the size of the window between plateaus controls the size of the base region. Shrinking the size of the window and increasing the thickness of these innerwalls decreases the size of the features. The transistor can be fabricated by either a lift-off process or an etch-back process.

## BRIEF DESCRIPTION OF THE DRAWINGS

FIGURE 1 is a cross-sectional perspective view of a transistor according to the present invention.

FIGURES 2a-2i are cross-sectional views illustrating the steps for forming the transistor according to the etch-back method disclosed herein.

FIGURES 3a-3j are cross-sectional views illustrating the steps for forming the transistor according to the lift off method disclosed herein.

DESCRIPTION OF THE PREFERRED EMBODIMENTS

The following description is the best presently contemplated mode of carrying out the invention. This description is made for the purpose of illustrating the general principles of the invention and is not to be taken in a limiting sense. The scope of the invention is best determined by the appended claims.

FIGURE 1 is a cross-sectional perspective view of a transistor 10 made according to the etch-back method described below. The transistor has a two-layer substrate. The lowest layer 12 is formed of silicon and is relatively heavily doped with an N type impurity (N+). The layer 14 also has an N type impurity but has a lower concentration of this impurity (N-). The N- layer 14 of the substrate functions as the collector region of the transistor. Around the perimeter of the substrate is a ring of recessed oxide (ROX) 16. This ROX ring reduces the metal capacitance in the transistor and increases the breakdown voltage of the transistor. A number of P+ regions 18 are silicon regions in the collector that have been doped to a very high impurity level of a P type impurity. Between the P+ regions are the base regions 19 which have a lesser concentration of the P type impurity, indicated by a P-. The P+ regions 18 are substantially adjacent to the base regions along the surface of the substrate 15.

A plurality of silicide/dielectric plateaus are formed above the P+ regions. Each plateau has a silicide layer 22 and a dielectric layer 23. The silicide layer forms part of the ohmic contact for the base regions. If the silicide were in direct contact with the base regions, a Schottky barrier of several tenths of a volt would be formed at the silicide-base points of contact. The P+ regions 18 are used to prevent such Schottky barriers. On top of each silicide layer 22 is a region of a first dielectric material 23. The plateaus of silicide and dielectric are surrounded by a wall or a frame 24 of a second dielectric material formed adjacent to the plateaus. A plurality of N- emitter regions 26 are formed over the walls 24 and partially penetrate each base region in the area between the walls. The dielectric walls also insulate the emitter from the silicide regions, which are part of the ohmic base contacts.

The transistor will have a metallic collector contact attached to the N+ region and a metallic contact connecting the emitter regions together. In addition, the silicide regions are joined together and have a metallic contact. For purposes of clarity, these contacts have been omitted from FIGURE 1.

Although FIGURE 1 shows only two emitter and two base regions with three P+ regions, usually there will be more than two base regions and emitter regions. A typical transistor may have one hundred or more base and emitter regions. The applicant has found that a transistor as described above will have a parasitic base resistance that is less than ten ohms.

A. <u>The Etch-Back Process</u>.

The transistor described above may be formed by an etch-back process. In an etch-back process, openings are made in one or more layers by reactive ion etching, chemical etching or other etching techniques and additional materials are implanted in those openings.

The formation of the transistor by the etch-back process starts with a sandwich comprising a silicon substrate 100 with a silicide layer 102 deposited on top of the substrate and a dielectric layer 104 on top of the silicide layer (FIGURE 2a). The substrate has been doped with an N type impurity. The substrate has two different concentration layers of the N type impurity, namely, an N+ impurity layer 106 and an N- impurity layer 108. The silicide layer 102 has a very high concentration of a P type impurity, which is represented by a P+. To form the silicide layer, silicide is sputtered in the presence of boron, which is the P type impurity. The dielectric is typically silicon dioxide.

In the next step, photoresist is used to form the pattern of the windows which define the base regions (FIGURE 2b). Photoresist 110 is deposited on top of the dielectric layer and treated, forming a plurality of windows 112, which are generally elongated and spaced apart from each other. Typically, these windows are approximately one and a half microns wide so conventional photolithography techniques can be used to make the windows. For the purpose of clarity, FIGURE 2b shows the formation of only one window. A region 114 of the dielectric layer 104 is exposed by each window.

After forming the windows in the photoresist, those regions of the dielectric 114 exposed by the windows 112 are removed to form the structure shown in FIGURE 2c. A chemical etchant that has a preference for dielectric can be used or reactive ion etching can be used. The windows 112 now extend through the dielectric, thereby exposing a region 116 of the silicide layer 102 in each window.

The exposed regions 116 of the silicide layer must be removed to form the structure shown in FIGURE 2d. Again, either a chemical etchant with a preference for silicide or reactive ion etching is used. A portion of the substrate 108 is exposed to view by each window. The remaining photoresist 110 is then removed. The windows are substantially spaced apart and elongated and the remaining dielectric and silicide forms the silicide/dielectric plateaus between the windows.

Next, base regions are implanted in the exposed portions of the substrate as shown in FIGURE 2e. This is usually done by ion implantation of a P type impurity such as boron. Then the base is annealed simultaneously with the silicide, allowing the base region to penetrate into the substrate. Thus, the plateaus act as masks for the formation of the bases. A base region 19 is shown in FIGURE 2e.

While the base regions 19 are annealed, the P type impurity in the silicide diffuses into the substrate beneath the silicide layer to form the P+ regions 18 as shown in FIGURE 2f. Due to the diffusion of the P type impurity, these P+ regions 18 extend into the portion of the substrate exposed to view by the window 112.

After forming the P+ regions, a second layer of dielectric 120 is formed by applying a dielectric such that the second layer forms a conformal coat, i.e., the thickness of the dielectric on the vertical surfaces of the windows equals the depth of the layer atop the horizontal surfaces of the device (FIGURE 2g). Some examples of processes that will deposit a conformal coated layer of dielectric are ESLC, LTO or LPCVD. The depth of this layer is controlled very precisely, 0.5 microns being typical. If the depth of the dielectric layer on horizontal surfaces is 0.5 microns, then the thickness of the dielectric on vertical surfaces will also be 0.5 microns.

Next, the uniform depth of the second dielectric layer is removed as shown in FIGURE 2h. This uniform depth of dielectric is usually removed by reactive ion etching. The only remaining portion of the second dielectric is a wall or a frame 24 of dielectric formed around the inner border of the window. The frames enlarge the silicide/dielectric plateaus by their thickness. Because there is a frame 24 on each of the plateaus that forms the window, they reduce the width of the window by twice the thickness of a wall. These frames serve as masks for forming an emitter region 26 in each window. Since the window 112 shown in FIGURE 2e is typically 1.5 microns wide and both of the frames 24 on each side of the window are typically 0.5 microns thick, this leaves approximately 0.5 microns of space for the emitter region to contact the base region. Thus the desired submicron geometry is attained.

The transistor is completed by forming the emitters 26 using ion implantation or other similar techniques as shown in FIGURE 2i. Finally, external contacts are formed (not shown).

B. The Lift-Off Process

This transistor can also be made by a lift-off process. In a lift-off process, a layer of photoresist is deposited on top of a structure of semiconductor materials and sections of the photoresist are removed forming photoresist plateaus with windows between the plateaus. Then more semiconductor and dielectric materials are deposited on top of the device and the remaining photoresist is removed; the materials that were deposited on top of the photoresist plateaus are also removed, leaving the materials deposited in the windows.

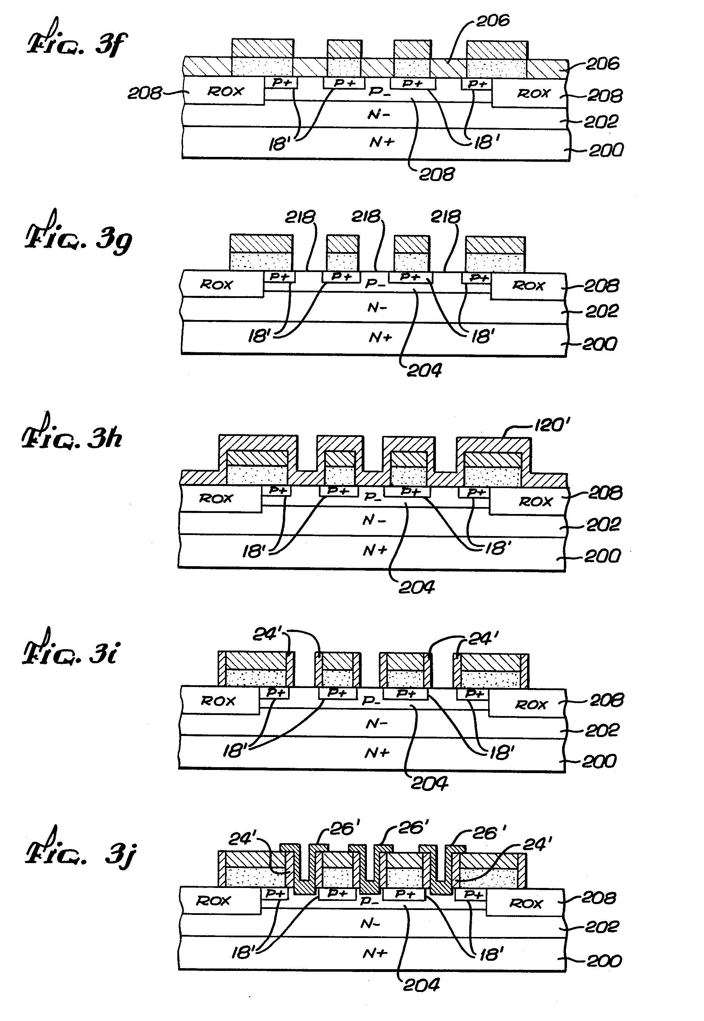

Although the lift-off process ends up with a transistor that is slightly different in configuration than the transistor formed by the etch-back process, the performance of the transistors are quite similar. Elements in FIGURES 3a-3j that have a similar function to elements in FIGURES 1 and 2a-2j are indicated by primed numbers.

The lift-off process starts with a substrate consisting of an N+ region 200 and an N- region 202 of silicon and a P- layer 204, which is the base layer (FIGURE 3a). An optional thin layer of an oxide 206 may be applied to the surface of the base region. A ring of ROX 208 is formed about the transistor.

Next, a layer of photoresist 209 is applied over the top of the base layer 204 or if there is a thin oxide layer, the photoresist is applied on top of the oxide layer 206. A pattern of elongated spaced apart windows 210 are formed in the photoresist by standard techniques (FIGURE 3b) and if the optional thin oxide layer is present, then those portions of the thin oxide layer exposed by the windows in the photoresist are removed as shown in FIGURE 3c. Typically, the photoresist plateaus will be about 1.5 microns wide between the windows. Thus, a number of elongated spaced apart windows are formed and the windows are separated by elongated spaced apart photoresist plateaus 212. These plateaus comprise photoresist deposited on top of the remainder of the thin oxide layer 206 (if any).

A layer of silicide 214 that has been doped with a P- type impurity is formed over the entire surface of the structure. As shown in FIGURE 3d, this silicide layer is a split layer, with part of the silicide layer being formed on top of the plateaus 212. Then, a split layer of silicon dioxide 216 is deposited.

Following the deposition of the silicon dioxide layer, the remaining photoresist 209 is lifted off by using a solvent for photoresist. The silicide and the silicon dioxide on top of the photoresist are also removed as shown in FIGURE 3d. This lift-off process results in silicide/dielectric plateaus of silicide regions 214 and silicon dioxide regions 216 being formed across the surface of the transistor as shown in FIGURE 3e. Because the removed photoresist plateaus are typically 1.5 microns wide, the windows between neighboring silicide/dielectric plateaus will also be 1.5 microns wide. After lifting off the photoresist, the silicide must be annealed to create the P+ regions that will serve as the anti-Schottky regions 18', as shown in FIGURE 3f. If an optional thin oxide layer 206 is used, the remainder of this layer must be removed by either reactive ion etching or chemical etching (FIGURE 3g).

From this juncture, the lift-off process for making the transistor is identical to the etch-back process. A conformal coated layer of dielectric 120' having a specified depth is deposited (FIGURE 3h). A depth of 0.5 microns is typical. Then the specified depth is removed, forming the inside border or frames 24' as described above (FIGURE 3i). If the specified depth is 0.5 microns this border will be approximately one-half micron thick. Because each window between the silicide/dielectric plateaus is typically 1.5 microns, the remaining gaps between the plateaus for formation of the emitter-base junctions are also 0.5 microns wide.

The emitter regions 26' are then formed in the exposed portions of the base as shown in FIGURE 3j. The metallic contacts are then formed, joining the emitter regions together.

There are some differences between the transistor if it is formed by a lift-off process instead of the etch-back process. These differences can be seen by comparing FIGURE 3j with FIGURE 1. The main difference is that there is one base layer 204 in a transistor formed by the lift-off process instead of separate base regions 19 in a transistor made by the etch-back process. In addition, the P+ anti-Schottky regions 18' are formed in the base layer instead of in the substrate.

Thus, a transistor is achieved with a low $r_b'$ value. Through the methods disclosed, it is possible to achieve a submicron geometry. The silicide layer also has the impurity to form part of the ohmic contact and is a mask for the formation of the base regions. The invention as shown is for an NPN transistor but the same principles can be applied to form a PNP transistor. Of course, any one of a number of different methods can be used for formation of the bases, the emitters and depositions and removals of the silicide and dielectric layers.

CLAIMS:

1. A bipolar transistor comprising:

a substrate having a first conductivity type impurity;

at least two elongated, spaced apart base regions formed on a surface of the substrate, said regions having an opposite conductivity type impurity;

at least three elongated, spaced apart anti-Schottky regions having a higher concentration of the opposite conductivity type impurity than the base regions, wherein the anti-Schottky regions are adjacent to the base regions and the base regions separate the anti-Schottky regions;

a plateau substantially covering each anti-Schottky region, wherein each plateau includes a layer of silicide adjacent to said elongated region with a higher concentration of said opposite conductivity type impurity and a layer of dielectric remote from said higher concentration region;

an emitter formed in each base region, wherein said emitter has an impurity of the first conductivity type; and

a border of dielectric formed around each emitter, wherein the silicide in the plateaus does not contact the emitter.

2. A bipolar transistor comprising:

a substrate semiconductor layer having an impurity of a first conductivity type, wherein the substrate layer forms the collector of the transistor and has a planar surface;

a plurality of spaced apart elongated semiconductor base regions formed in said surface of the substrate, wherein each base region has an impurity of an opposite conductivity type from said first conductivity type;

a plurality of anti-Schottky regions of semiconductor material formed in said surface of the substrate layer, having a higher concentration of the same conductivity type impurity as the base regions, such that the anti-Schottky regions extends adjacent to each base region, separating the base regions;

a silicide layer formed on top of each anti-Schottky region wherein the silicide layer forms windows such that the silicide layer does not substantially cover any base region, said silicide layer having a surface remote from the substrate;

an emitter region formed on the surface of each base region, wherein the emitter region does not contact the silicide layer;

means for joining all the silicide layers together;

means for insulating the emitter region from the silicide layer;

means for insulating the surface of the silicide layer remote from the base regions; and

means for connecting together all of the emitter regions.

3. A bipolar transistor as described in claim 2, wherein said anti-Schottky region has the same impurity type as the base region.

4. A bipolar transistor as described in claim 3, wherein the means for insulating the emitter from the silicide layer is a dielectric border between the emitter region and the silicide layers.

5. A bipolar transistor as described in claim 4, wherein the means for insulating the surface of the silicide layer is a dielectric layer on the surface of said silicide layer remote from said substrate.

6. A bipolar transistor as described in claim 5, wherein the dielectric border and the dielectric layer are made of silicon dioxide.

7. A bipolar transistor as described in claim 6, wherein the impurity in all base regions and the anti-Schottky regions is boron.

8. A bipolar transistor as described in claim 7, wherein the substrate layer comprises:

a layer of relatively low concentration of said first impurity adjacent to the base regions, wherein the low concentration region forms the collector; and

a layer of relatively high concentration impurity remote from the base regions.

9. A bipolar transistor as described in claim 8, further including a metal contact to the silicide layer and a metal contact to the layer of higher concentration in the substrate layer.

10. A bipolar transistor as described in claim 9, further including a recessed oxide ring substantially surrounding the anti-Schottky regions and the collector layer in the substrate, wherein said recessed oxide raises the breakdown voltage of the transistor and reduces metal capacitance.

11. A bipolar transistor comprising:

a substrate semiconductor layer having an impurity of a first conductivity type, wherein the substrate layer forms a collector and the substrate layer has a surface;

a semiconductor base layer having an impurity of an opposite conductivity type, said base layer is formed in the surface of said substrate layer, whereby the semiconductor base layer has a surface remote from the surface of the substrate;

a plurality of elongated spaced apart semiconductor channels having a higher concentration of the same conductivity type impurity as the base layer, said semiconductor channels formed on the surface of the base layer, wherein a plurality of elongated spaced apart regions of the base layer are exposed on said surface of the base layer;

silicide regions substantially covering each semiconductor channel, wherein said silicide regions are joined together forming a window around each of the spaced apart base regions;

an emitter semiconductor region formed in each base region exposed by the windows, wherein the emitter region has an impurity of said first conductivity type;

means for insulating each emitter region from the silicide regions;

means for connecting all the emitter regions together; and

a contact for the substrate layer.

12. A bipolar transistor comprising:

a collector substrate layer having an impurity of a first conductivity type;

a plurality of spaced apart elongated base regions formed on the surface of the substrate wherein each base region has an impurity of the opposite conductivity type as the collector substrate layer;

a plurality of spaced apart elongated anti-Schottky regions on the surface of said substrate, wherein each anti-Schottky region has a higher concentration of the same impurity than is in each base region, and wherein the base regions are separated from each other by an anti-Schottky region;

a silicide region substantially covering each anti-Schottky region, wherein each silicide region contains the same impurity as in the base region;

one region of dielectric substantially covering each silicide region, wherein each silicide region and dielectric region on top of said silicide region form an elongated plateau on the surface of said substrate;

a plurality of emitter regions, wherein each emitter region is formed in the base region between two plateaus;

a border of a second dielectric substantially surrounding each emitter region, wherein the emitter region is insulated from the silicide regions;

means for connecting all of the silicide regions together;

metallic contacts on top of each emitter region, wherein all of the emitter regions are connected together by the metallic contacts; and

a metal contact connected to the substrate remote from the base regions, wherein said metal contact is the contact for the collector.

13. A process for making a bipolar transistor, comprising the steps of:

a) depositing a layer of silicide having an impurity of a first conductivity type on top of a substrate having an impurity of an opposite conductivity type;

b) depositing a layer of dielectric on top of said silicide layer;

c) forming a plurality of elongated spaced-apart windows on top of said dielectric layer by depositing a layer of photoresist on top of said dielectric layer, forming a pattern on said photoresist, developing said photoresist, and removing part of the photoresist to form the windows in the photoresist;

d) removing the portions of the dielectric layer exposed by the windows, wherein each window extends through both the photoresist layer and the dielectric layer;

e) removing the portions of the silicide layer exposed by the windows, wherein each window extends through the photoresist, dielectric, and silicide layers thereby exposing a plurality of portions of the substrate;

f) removing the remainder of the photoresist layer;

g) implanting a base region in each portion of the substrate that is exposed by the window, wherein each base region has the same impurity as the silicide layer;

h) forming a plurality of anti-Schottky regions having the first type impurity in the substrate substantially beneath the remainder of said silicide layer;

i) forming a border of a dielectric around the entire edge of each window, wherein part of each base region is covered;

j) forming an emitter region in the remainder of each base region that is exposed, wherein the border of dielectric formed in each window insulates the emitter in regions the window from the silicide; and

k) forming contacts to connect the emitter regions together, forming a contact to the silicide layer and forming a contact to the substrate.

14. A process for making a bipolar transistor as described in claim 13, wherein step f is done before step e and step h is performed before step g.

15. A process for making a bipolar transistor as described in claim 13 wherein step h is performed after step i.

16. A process for making a bipolar transistor as described in claim 13, wherein the anti-Schottky regions have a higher concentration of said first conductivity type impurity than the base regions.

17. A process for making a bipolar transistor as described in claim 16, wherein said first conductivity type impurity is mixed into the silicide by sputtering the silicide in the presence of boron to form the silicide layer.

18. A process for making a bipolar transistor as described in claim 17, wherein the method for forming the base is ion implantation.

19. A process for making a bipolar transistor as described in claim 18, wherein the procedure for forming the wall comprises the steps of:

after forming the base regions, depositing a conformal coated second layer of a dielectric of a specified depth;

removing approximately said specified depth from the entire transistor, wherein the entire second layer of dielectric is removed except for a wall of dielectric around the edge of each window, whereby the depth of the second layer of the dielectric dictates the thickness of the borders.

20. A lift-off process for forming a bipolar transistor comprising:

forming a base layer having an impurity of a first conductivity type on top of a substrate having an impurity of an opposite conductivity type;

depositing a layer of photoresist on top of the base layer, forming a pattern of spaced apart elongated regions in the photoresist and removing those regions;

depositing a layer of silicide on top of the entire transistor including the windows in the photoresist, wherein said silicide layer has the same conductivity type impurity as the base layer;

depositing a layer of dielectric on top of silicide;

lifting-off the photoresist remaining on the transistor, wherein the top surface of the transistor has a plurality of elongated spaced apart plateaus, wherein each plateau includes a layer of silicide adjacent to the base region and a layer of dielectric above the silicide layer;

forming a wall of dielectric substantially surrounding each plateau;

driving the impurity contained in the silicide into the base region, wherein substantially beneath each plateau an anti-Schottky region is formed on the surface of the base layer wherein the anti-Schottky barrier layer has a higher concentration of the impurity than the surrounding base region;

forming an emitter region between each plateau; and

attaching metal contacts to connect the emitter regions together, attaching a metal contact to the silicide layer, and attaching a metal contact to the collector substrate.

21. A process for forming a transistor as described in claim 20, wherein the method for forming the wall around the plateaus comprises the steps of:

depositing a conformal coated second layer of a dielectric of a specified thickness,

removing the specified thickness of the second dielectric, wherein the only material left from the second layer of dielectric is a wall formed around each plateau.

22. A process for forming a bipolar transistor as described in claim 21, comprising the additional steps of:

forming a thin oxide layer on top of the base region before forming the photoresist layer;

after forming the windows in the photoresist, etching off the thin oxide exposed by the windows; and

after lifting off the photoresist to form the plateaus etching off the thin oxide layer between the plateaus.

0133339



Fig. 1

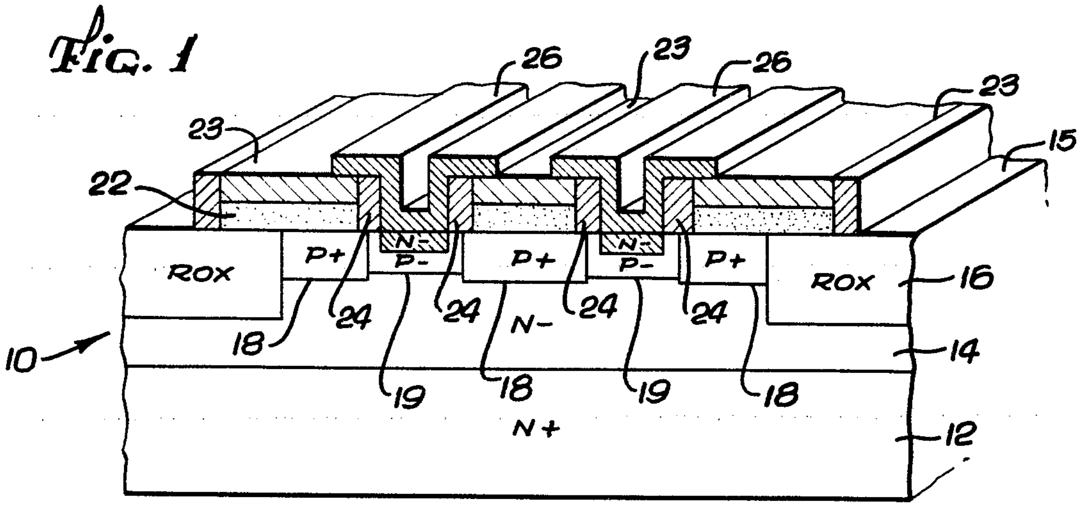


Fig. 2a

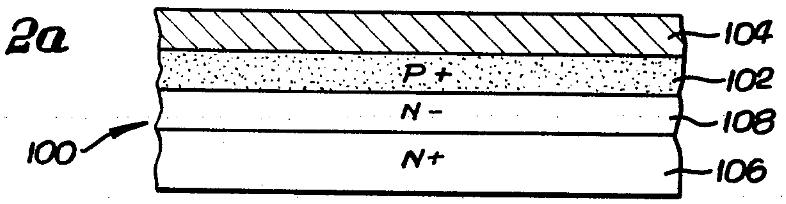


Fig. 2b

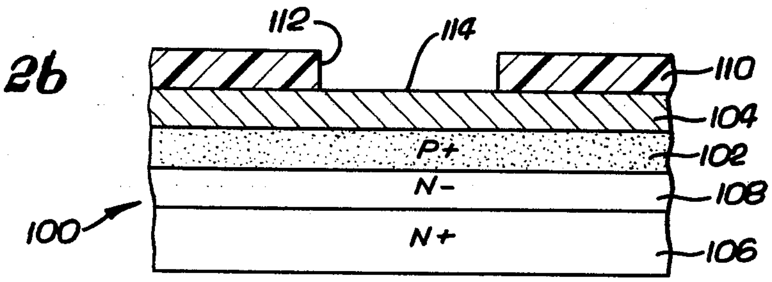


Fig. 2c

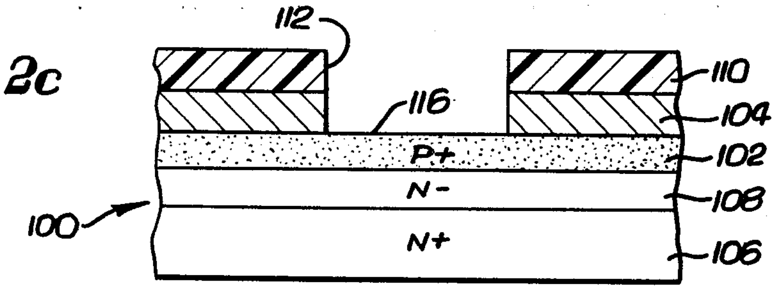


Fig. 2d

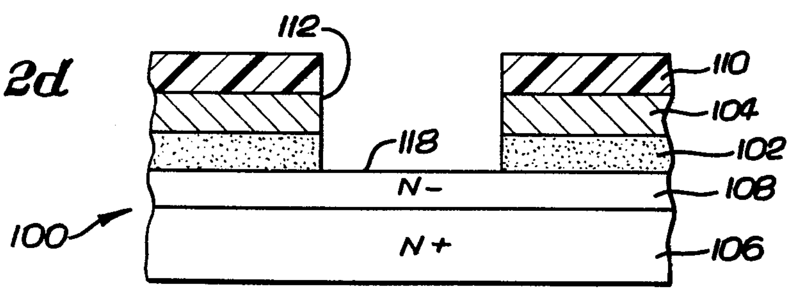

*Fig. 2e*

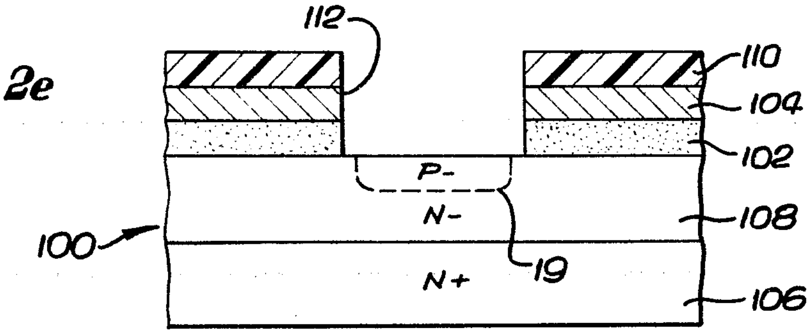


*Fig. 2f*

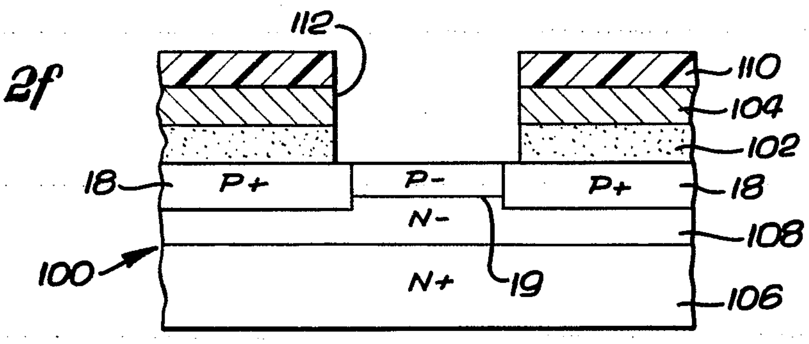


*Fig. 2g*

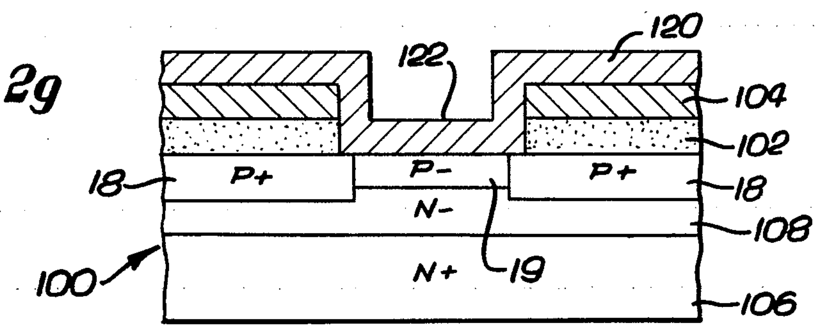


*Fig. 2h*

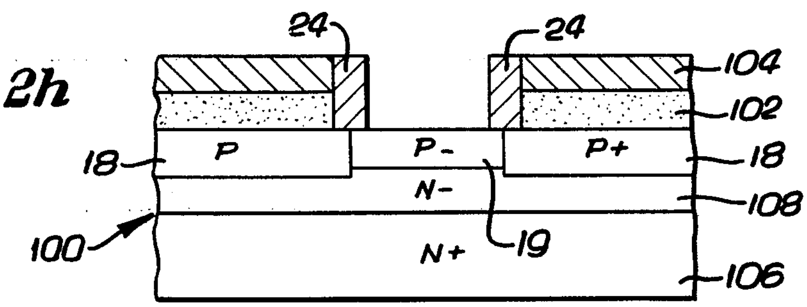


*Fig. 2i*

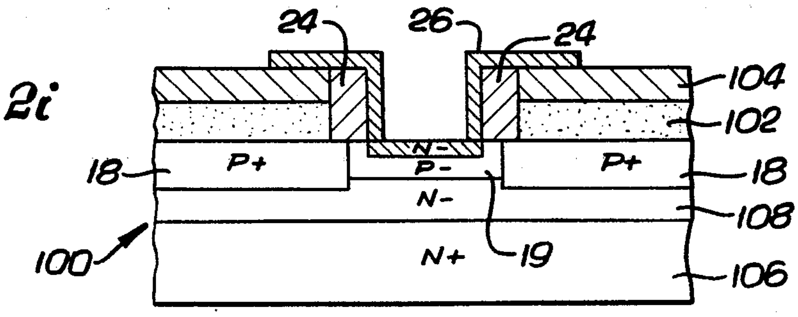

*Fig. 3a*

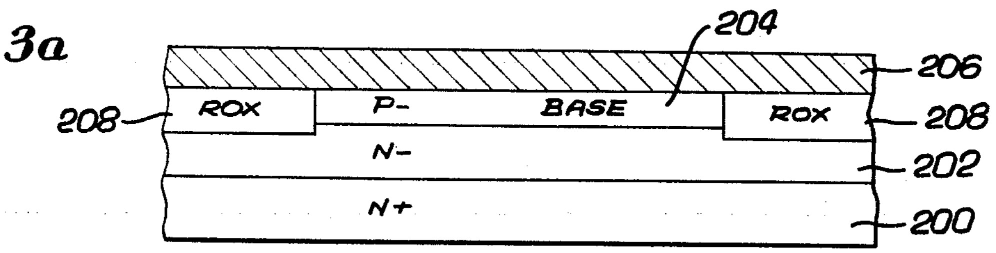


*Fig. 3b*

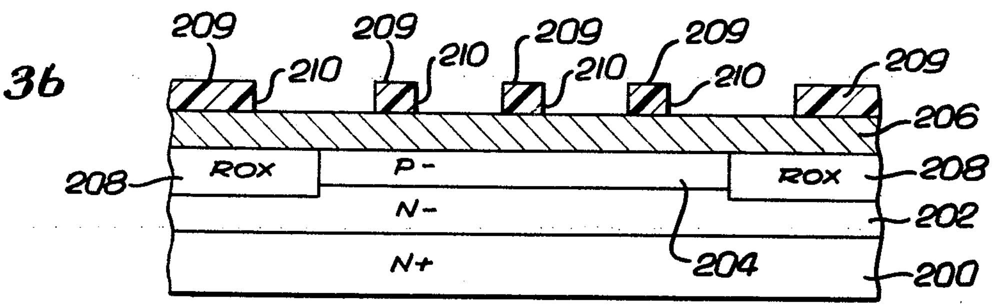


*Fig. 3c*

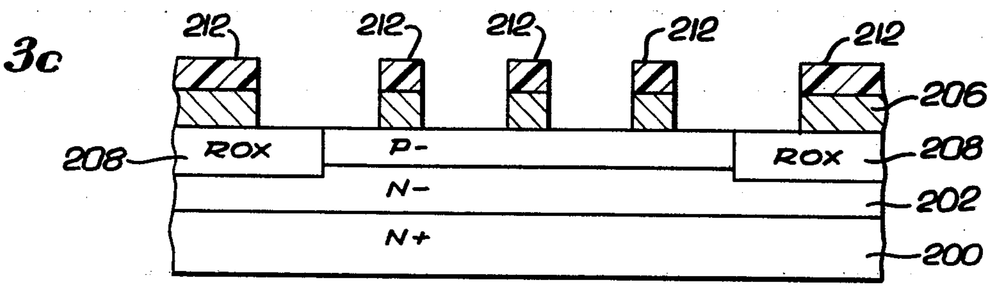


*Fig. 3d*

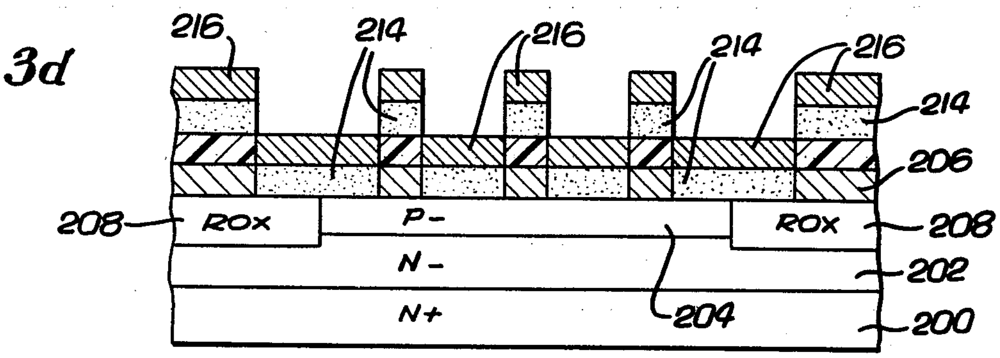


*Fig. 3e*

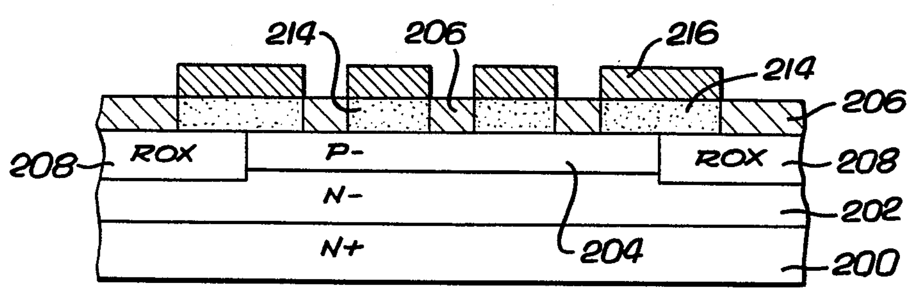

Fig. 3f

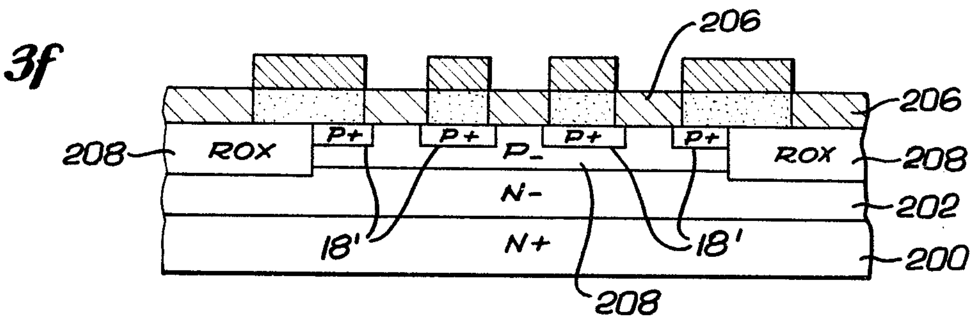


Fig. 3g

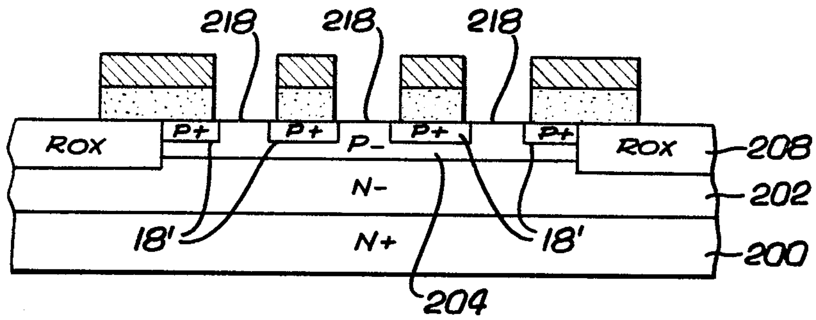


Fig. 3h

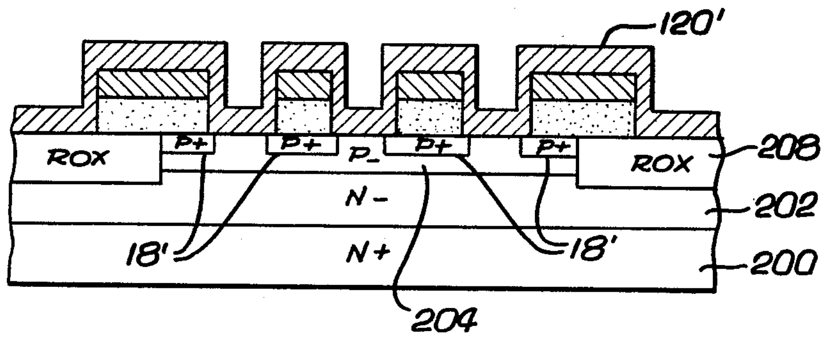


Fig. 3i

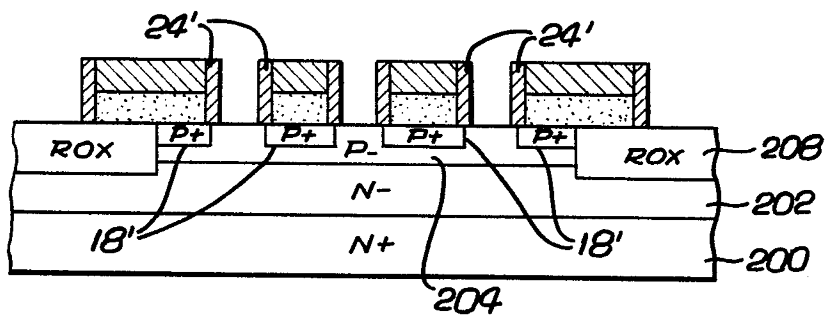


Fig. 3j